# EUROPEAN PATENT APPLICATION

(11) **EP 1 993 172 A1**
(43) Date of publication of application: **19.11.2008**
(21) Application number: 07706598.5
(22) Date of filing: 11.01.2007
(51) Int. Cl.: H01R 12/04, H01R 4/02, H01R 12/22, H01R 24/00, H05K 1/18

(54) **FIXER, SURFACE-MOUNT COMPONENT USING THE FIXER, AND MOUNTING STRUCTURE USING THE FIXER**

(30) Priority: 12.01.2006 JP 2006004422
(71) Applicant: Tyco Electronics AMP K.K., Kawasaki-shi, Kanagawa-ken 213-8535 (JP)
(72) Inventor: KAWAHARA, Yuzo, Kawasaki-shi Kanagawa 2138535 (JP)
(74) Representative: Klunker . Schmitt-Nilson . Hirsch
(86) International application number: PCT/JP2007/050251
(87) International publication number: WO 2007/080927

(57) **Abstract**

A fixer for preventing degradation of the board holding strength even if the mounting area is decreased compared to conventional, a surface-mount component having this fixer, and a mounting structure using this fixer are provided. A fixer (20) is used to solder an object to be connected onto a circuit board (PCB). The fixer (20) has a fixed section (21) to be fixed to the side of the object and a solder connection section (22) extending from the fixed section (21) and soldered to the surface of the circuit board (21). The end of the solder connection section (22) is folded back outward into a U shape, and the linear ridge portion (22a) is in contact with the surface of the circuit board (PCB). On both sides of the ridge portion (22a), solder fillets (30) are near to each other and formed into one piece.

## Description

### TECHNICAL FIELD

The present invention relates to a fixer for connecting an object to be connected by soldering onto the surface of a circuit board, a surface-mount component comprising this fixer, and a mounting structure using this fixer.

### BACKGROUND ART

Surface-mount components such as electrical connectors that are mounted on a circuit board have conventionally been provided with fixers for connecting such a surface-mount component by soldering onto the surface of a circuit board. Fixers that have been known as such fixers include fixers which are constructed from plate-form components and which are fastened to both side surfaces of the surface-mount component and connected by soldering onto the surface of the circuit board, or fixers which are provided as part of a metal shell that covers the surface-mount component and which are connected by soldering onto the surface of the circuit board.

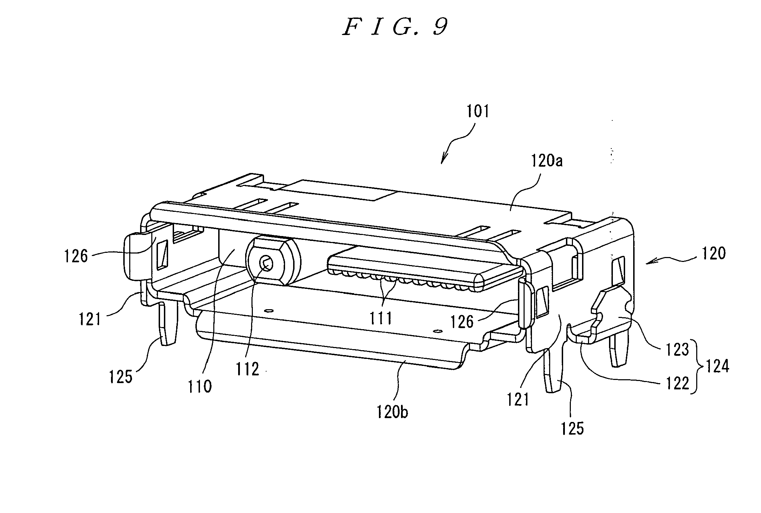

The fixer shown in FIG. 9 (see Japanese Patent Application Kokai No. H10-21993), for example, has been known as a conventional example in which fixers are provided as part of a shell that covers such a surface-mount component. FIG. 9 is a perspective view of one example of a conventional shield connector.
The shield connector 101 shown in FIG. 9 is designed to be mounted on a circuit board (not shown in the figure), and comprises an insulating housing 110 that has a plurality of contacts 111 and a coaxial contact 112, and a metal shell 120 that covers this housing 110. This shell 120 comprises an upper shell 120a having downwardly facing side walls 121, 121 at both ends and a lower shell 120b having upwardly facing side walls 126, 126 at both ends.

Furthermore, fastening parts (fixers) 124, each comprising a horizontal part 122 that extends horizontally outward and an engaging projection 123 that is bent from the tip end of the horizontal part 122 and then extends upward, are respectively provided substantially in the central portions at the lower ends of the two side walls 121 of the upper shell 120a. Moreover, a pair of leg parts 125 protrude downward from the lower end of each of the two side walls 121 of the upper shell 120a.
This shield connector 101 is designed to be mounted on a circuit board by passing the leg parts 125 through through-holes formed in the circuit board and making solder connection, and also by connecting all of the horizontal parts 122 of the fastening parts 124 by soldering to the surface of the circuit board.

Here, the shield connector 101 mounted on the circuit board maintains the board holding strength with respect to the circuit board as a result of the leg parts 125 being connected by soldering to the through-holes formed in the circuit board. This board holding strength is reinforced by connecting all of the horizontal parts 122 of the fastening parts 124 by soldering to the surface of the circuit board.
Accordingly, in cases where an external force acts in a direction in which the shield connector 101 is pulled away from the circuit board in the state of being mounted on the circuit board, this pulling away can be prevented by possessing the board holding strength with respect to the circuit board by means of the leg parts 125 and fastening parts 124.

### DISCLOSURE OF THE INVENTION

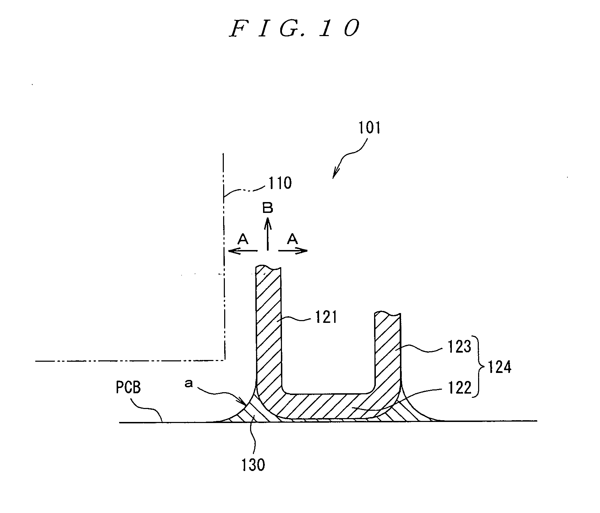

However, the following problems have been encountered in the conventional shield connector 101 shown in FIG. 9:
Specifically, as is shown in FIG. 10, when all of the horizontal parts 122 of the fastening parts 124 are connected by soldering to a circuit board PCB, solder fillets indicated by the symbol 130 are formed along the circumferences of the horizontal parts 122. In this state, if an external force acts which causes the shield connector 101 to move in the horizontal directions indicated by the arrows A or if an external force acts which pulls the shield connector 101 apart in the vertical direction indicated by the arrow B, due to vibration, changes in ambient temperature, or other such factors, the force in the horizontal directions indicated by the arrows A and the force in the vertical direction indicated by the arrow B act on the fastening parts 124 provided on the upper shell 120a. In this case, because the fastening parts 124 are part of the shell 120 mounted on the housing 110 of the shield connector 101, stress tends to be concentrated in the portions of the solder fillets 130 indicated by "a" on the side of the shield connector 101. That is, among the solder fillets 130 attached to the horizontal parts 122, the portions of the solder fillets 130 indicated by "a" on the side of the shield connector 101 contribute most significantly to the board holding strength, and the degree of contribution of the other portions is low. Therefore, while the board holding strength is not increased much even if the horizontal parts 122 are extended outward more than necessary and connected by soldering, this ends up creating the problem of increasing the mounting areas of the fastening parts 124, i.e., the mounting area of the shield connector 101.

Accordingly, the present invention was devised in light of the problems described above; it is an object of the present invention to provide a fixer that can prevent a drop in the board holding strength even if the mounting area is made smaller than in the past, a surface-mount component comprising this fixer, and a mounting structure using this fixer.
In order to solve the problems described above, the fixer of Claim 1 is a fixer for connecting an object of connection by soldering onto the surface of a circuit board, wherein this fixer comprises a plate-form fastening part that is fastened to a side surface of the object of connection and a solder connection part that extends from this fastening part and that is connected by soldering onto the surface of the circuit board, and the end portion of the solder connection part is bent back outward in the shape of the letter U, and the rectilinear ridge part thereof contacts the surface of the circuit board.

Furthermore, the fixer of Claim 2 is the fixer according to Claim 1, wherein the fastening part is provided with holding parts that hold the object of connection by contacting shoulder parts formed on this object of connection.
Moreover, the surface-mount component of Claim 3 is a surface-mount component comprising the fixer according to Claim 1 or 2.
In addition, the surface-mount component of Claim 4 is the surface-mount component according to Claim 3, wherein the fixer is accommodated in a recessed part formed in a side surface of the object of connection.
Furthermore, the mounting structure of Claim 5 is a mounting structure which uses the fixer according to Claim 1 or 2.

In the fixer of Claim 1, the end portion of the solder connection part that is connected by soldering onto the surface of the circuit board is bent back outward in the shape of the letter U, and the rectilinear ridge part thereof contacts the surface of the circuit board. Therefore, solder fillets are formed on both sides of the U-shaped ridge part in close proximity to each other as an integral unit, so that it is possible to increase the board holding strength per each mounting area. Because there is no horizontal portion in the contact part contacting the circuit board, the solder fillets on both sides can be formed in close proximity to each other, so that the area of the pads can be reduced. Accordingly, it is possible to obtain a fixer which can prevent a drop in the board holding strength even if the mounting area is made smaller than in the past.

Moreover, in the fixer of Claim 2, the fastening part that is fastened to a side surface of the object of connection is provided with holding parts that hold the object of connection by contacting shoulder parts formed on this object of connection in the fixer of Claim 1. Therefore, it is possible to reinforce the joining of the fixer and the object of connection, together with the fastening part.
In addition, because the surface-mount component of Claim 3 comprises the fixer according to Claim 1 or 2, a surface-mount component can be obtained which can prevent a drop in the board holding strength even if the mounting area is reduced. Furthermore, the joining of the fixer and the object of connection can be reinforced.

Moreover, in the surface-mount component of Claim 4, the fixer is accommodated in a recessed part formed in a side surface of the object of connection in the surface-mount component according to Claim 3. Therefore, the mounting area of the surface-mount component can be reduced even further.
Furthermore, because the mounting structure of Claim 5 uses the fixer according to Claim 1 or 2, a mounting structure can be obtained which can prevent a drop in the board holding strength even if the mounting area is reduced. Furthermore, the joining of the fixer and the object of connection can be reinforced.

### BRIEF DESCRIPTION OF THE DRAWINGS

FIG. 1 is a perspective view of an electrical connector used as a surface-mount component comprising the fixers of the present invention;
FIG. 2 shows the electrical connector of FIG. 1, with FIG. 2(A) being a front view, FIG. 2(B) being a left side view, and FIG. 2(C) being a sectional view along line 2C-2C in FIG. 2(B);
FIG. 3 is a perspective view of the fixer of the present invention as seen from the side that is on the outside when mounted on the housing;
FIG. 4 shows the fixer of FIG. 3, with FIG. 4(A) being a plan view, FIG. 4(B) being a front view, FIG. 4(C) being a bottom view, FIG. 4(D) being a right side view, and FIG. 4(E) being a rear view;
FIG. 5 is a perspective view showing a state in which the electrical connector of FIG. 1 is mounted on a circuit board;
FIG. 6 shows a state in which the solder connection part of each fixer is connected by soldering onto a conductive pad provided on the surface of the circuit board, with FIG. 6(A) being a front view, FIG. 6(B) being a right side view, and FIG. 6(C) being a sectional view along line 6C-6C in FIG. 6(A);
FIG. 7 is a diagram for illustrating the concentration of stress in cases where a fixer whose solder connection part is not formed in the shape of the letter U is connected by soldering onto the circuit board, and an external force acts on this fixer;
FIG. 8 is a diagram for illustrating the dispersion of stress in cases where the fixer of the present invention shown in FIG. 3 is connected by soldering onto the circuit board, and an external force acts on this fixer;
FIG. 9 is a perspective view of one example of a conventional shield connector; and
FIG. 10 is a diagram for illustrating the concentration of stress in cases where an external force acts on the fixers in the shield connector shown in FIG. 9.

### Explanation of Symbols

1: Electrical connector (surface-mount component)
10: Housing (object of connection)
14: Fixer accommodating recessed part (recessed part)
16: Shoulder part
20: Fixer
21: Fastening part
22: Solder connection part
22a: Ridge part
PCB: Circuit board

### BEST MODE FOR CARRYING OUT THE INVENTION

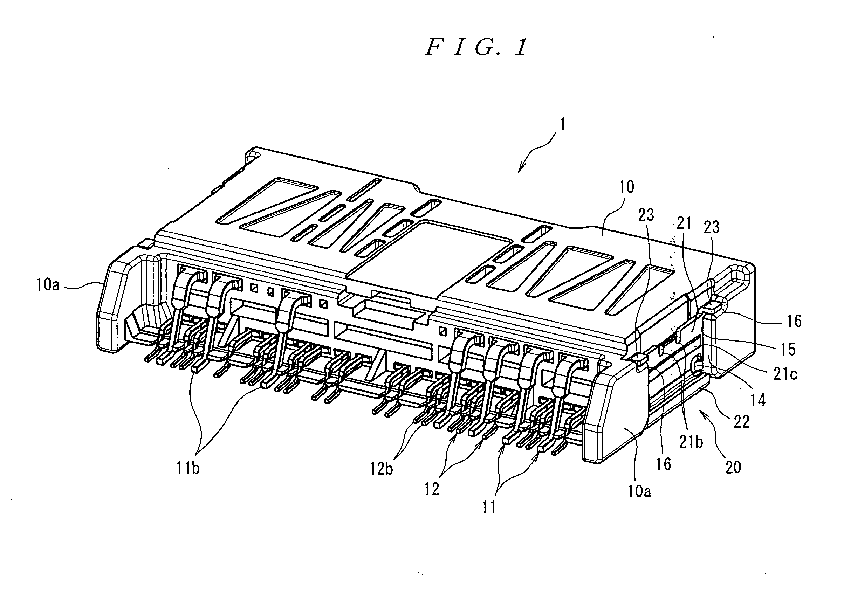

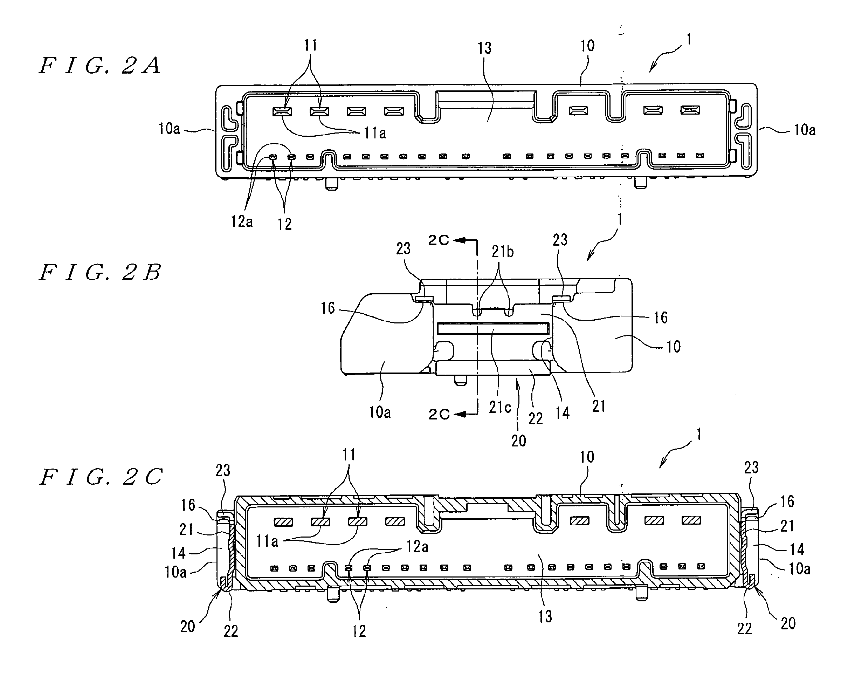

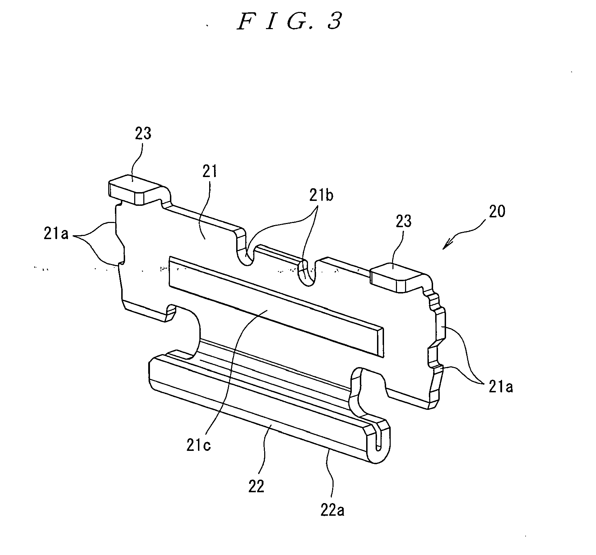

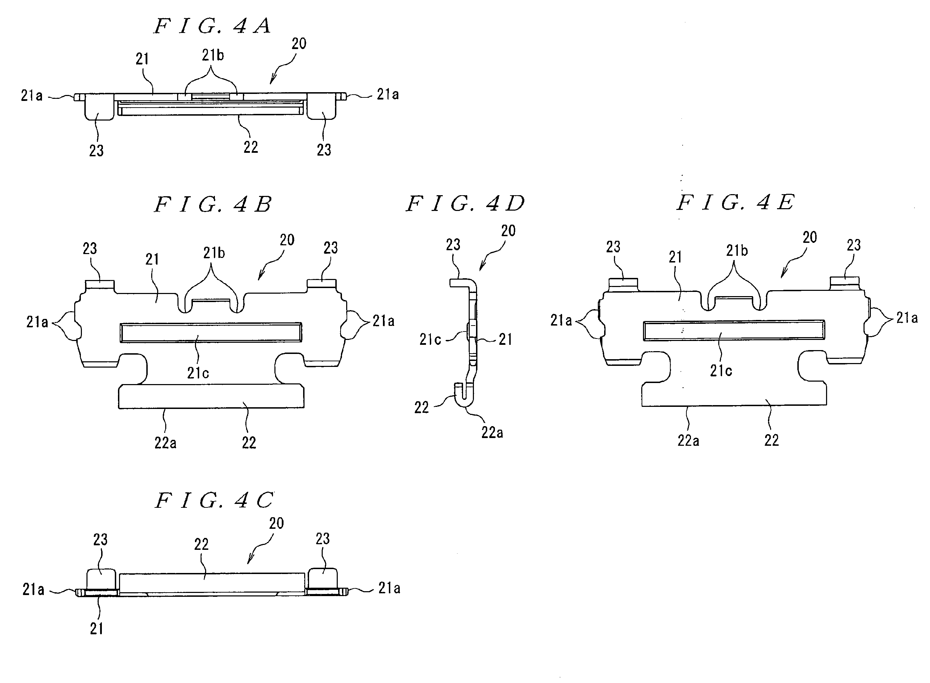

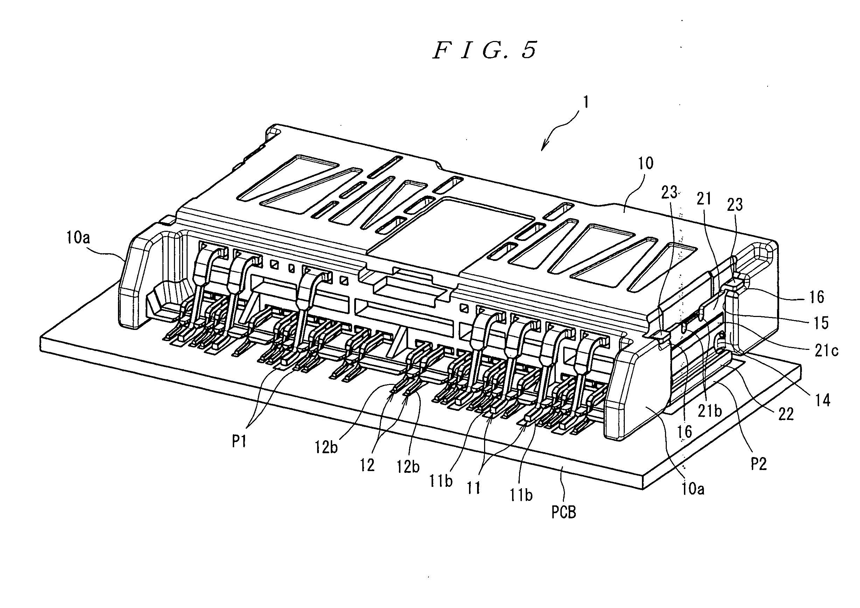

Next, an embodiment of the present invention will be described with reference to the figures. FIG. 1 is a perspective view of an electrical connector used as a surface-mount component comprising the fixers of the present invention. FIG. 2 shows the electrical connector of FIG. 1; FIG. 2(A) is a front view, FIG. 2(B) is a left side view, and FIG. 2(C) is a sectional view along line 2C-2C in FIG. 2(B). FIG. 3 is a perspective view of the fixer of the present invention. FIG. 4 shows the fixer of FIG. 3; FIG. 4(A) is a plan view, FIG. 4(B) is a front view, FIG. 4(C) is a bottom view, FIG. 4(D) is a right side view, and FIG. 4(E) is a rear view. FIG. 5 is a perspective view showing a state in which the electrical connector of FIG. 1 is mounted on a circuit board.

The electrical connector (surface-mount component) 1 shown in FIGS. 1 and 2 is designed to be mounted on a circuit board PCB, and comprises an insulating housing (object of connection) 10 having a plurality of power contacts 11 and a plurality of signal contacts 12, and a pair of fixers 20 for connecting the housing 10 by soldering onto the surface of the circuit board PCB.

Here, the housing 10 is formed in a substantially rectangular shape by molding an insulating resin, and comprises a mating connector receiving recessed part 13 that opens on the front surface (right surface in FIG. 2(B)) of the housing 10. The power contacts 11 and signal contacts 12 respectively comprise contact parts 11a and 12a that protrude into the mating connector receiving recessed part 13 as shown in FIGS. 2(A) and 2(C) and board connecting parts 11b and 12b that are connected by soldering onto the surface of the circuit board PCB as shown in FIG. 5. Furthermore, a mating connector (not shown in the figures) is received inside the mating connector receiving recessed part 13, so that the mating contacts (not shown in the figures) provided on the mating connector respectively make contact with the contact parts 11a and 12a of the power contacts 11 and signal contacts 12. Moreover, a pair of fixer accommodating recessed parts 14, 14 are respectively formed substantially in the central portions in the forward-rearward direction of the two side surfaces 10a, 10a of the housing 10 as shown in FIGS. 1 and 2. A pair of fastening part recessed parts 15, 15 that receive both ends of the fastening part 21 of each fixer 20 (described later) are respectively formed in the front wall part and rear wall part of each of the fixer accommodating recessed parts 14 as shown in FIG. 1 (FIG. 1 shows only the fastening part recessed part 15 formed in the front wall part of the fixer accommodating recessed part 14 on one side). Furthermore, shoulder parts 16, 16 that are respectively contacted by a pair of holding parts 23, 23 (described later) of a fixer 20 are provided on the upper surfaces of each of the two side surfaces 10a, 10a of the housing 10 on the front side and rear side of each fixer accommodating recessed part 14.

Moreover, the pair of fixers 20 are designed to be respectively accommodated inside the fixer accommodating recessed parts 14 formed in the two side surfaces 10a, 10a of the housing 10 as shown in FIG. 2(C). Each of the fixers 20 is formed by stamping and forming a metal plate. As is shown in FIGS. 1 through 4, each fixer 20 comprises a fastening part 21 whose both ends are received and press-fitted in the pair of fastening part recessed parts 15, 15 formed in each side surface 10a of the housing 10, and a solder connection part 22 that extends downward from the fastening part 21. The fastening part 21 is formed in a substantially rectangular plate form; a pair of cutouts 21b are formed in the upper edge, and a plurality of locking projections 21a that are press-fitted in the fastening part recessed parts 15, 15 of the housing 10 are provided so as to protrude from both edges of the fastening part 21 in the direction of width. A rib 21 c formed by coining is formed substantially in the central portion in the vertical direction of the fastening part 21. This rib 21 c has the function of reinforcing the plate-form fastening part 21.

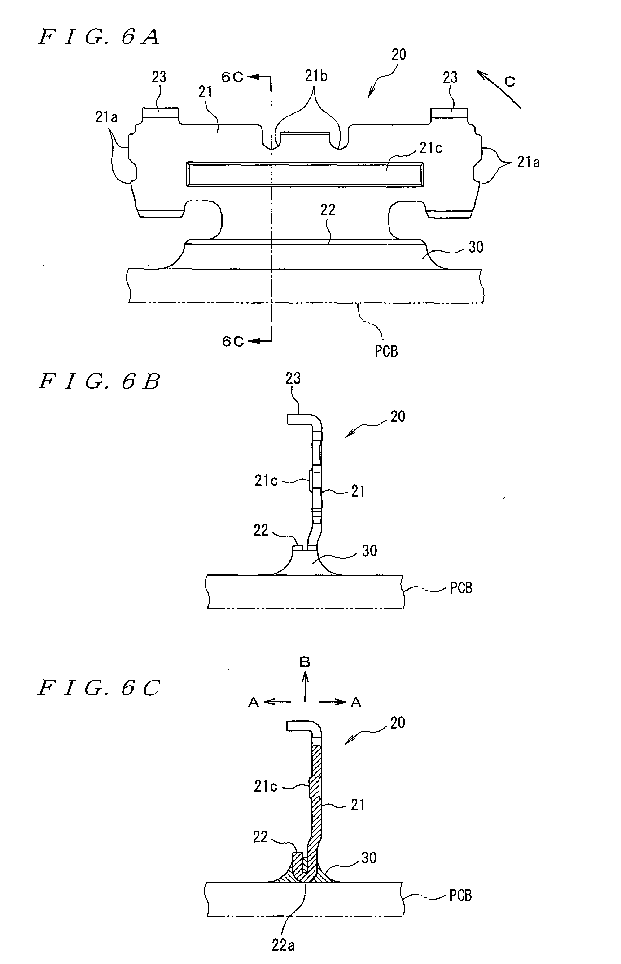

Furthermore, the solder connection part 22 extends downward substantially from the central portion in the direction of width of the lower edge of the fastening part 21, and is designed to be connected by soldering onto the surface of the circuit board PCB as shown in FIG. 5. As is shown in FIGS. 1, 2(C), 3, 4(D), and 5, the lower end portion of the solder connection part 22 is bent back outward (outward in the direction of width of the housing 10) in the shape of the letter U, so that the rectilinear ridge part 22a thereof contacts the surface of the circuit board PCB (see FIG. 6(C)).

Moreover, as is shown in FIGS. 3 and 4, a pair of holding parts 23, 23 that are bent outward are provided at either end in the direction of width of the upper edge of the fastening part 21 of each fixer 20. As is shown in FIG. 1, these holding parts 23, 23 respectively contact the shoulder parts 16, 16 formed on the housing 10, and have the function of reinforcing the joining of the fixer 20 and housing 10 together with the fastening part 21 when the electrical connector 1 is mounted on the circuit board PCB.

In addition, when the electrical connector 1 is mounted on the circuit board PCB as shown in FIG. 5, the board connecting parts 11b of the individual power contacts 11 and the board connecting parts 12b of the individual signal contacts 12 are respectively connected by soldering onto conductive pads P1 provided on the surface of the circuit board PCB, and the solder connection parts 22 of the individual fixers 20 are respectively connected by soldering onto conductive pads P2 provided on the surface of the circuit board PCB. The mounting strength of the electrical connector 1 mounted on the circuit board PCB with respect to the circuit board PCB is maintained mainly by the solder connection parts 22 of the respective fixers 20 being connected by soldering onto the conductive pads P2 provided on the surface of the circuit board PCB.

FIG. 6 shows a state in which the solder connection part of each fixer is connected by soldering onto a conductive pad provided on the surface of the circuit board; FIG. 6(A) is a front view, FIG. 6(B) is a right side view, and FIG. 6(C) is a sectional view along line 6C-6C in FIG. 6(A).
As is shown in FIGS. 5 and 6, when the solder connection parts 22 of the respective fixers 20 are connected by soldering onto the conductive pads P2 provided on the surface of the circuit board PCB, solder fillets 30 are formed around the solder connection parts 22. Furthermore, because the lower end portions of the solder connection parts 22 are bent back outward in the shape of the letter U as shown in FIG. 6(C), and the rectilinear ridge parts 22a thereof contact the surface of the circuit board PCB, the solder fillets 30 are formed on both sides of the U-shaped ridge parts 22a. Therefore, it is possible to increase the board holding strength of the fixers 20 per each mounting area, thus making it possible to prevent a drop in the board holding strength even if the mounting area is made smaller than in the past. Because the mounting area of the fixers 20 can be reduced, the mounting area of the electrical connector 1 can be reduced as a result. Consequently, in a state in which the solder connection parts 22 of the respective fixers 20 are connected by soldering to the conductive pads P2 provided on the surface of the circuit board PCB, even if an external force that causes the fixers 20 to move in the horizontal directions indicated by the arrows A or an external force that pulls the fixers 20 apart in the vertical direction indicated by the arrow B acts on the fixers 20 as shown in FIG. 6(C) due to vibration, changes in ambient temperature, or other such factors, there is no problem, so that the bonding strength (mounting strength) that is the same as or greater than in the past can be obtained even if the mounting area is reduced. Furthermore, even if an external force that causes the fixers 20 to rotate in the direction of the arrow C as shown in FIG. 6(A) (an external force that causes the fixers 20 to rotate in the direction of the plate width of the fixers 20) acts on the fixers 20, because the board holding strength of the fixers 20 per each mounting area is high, this does not become an issue.

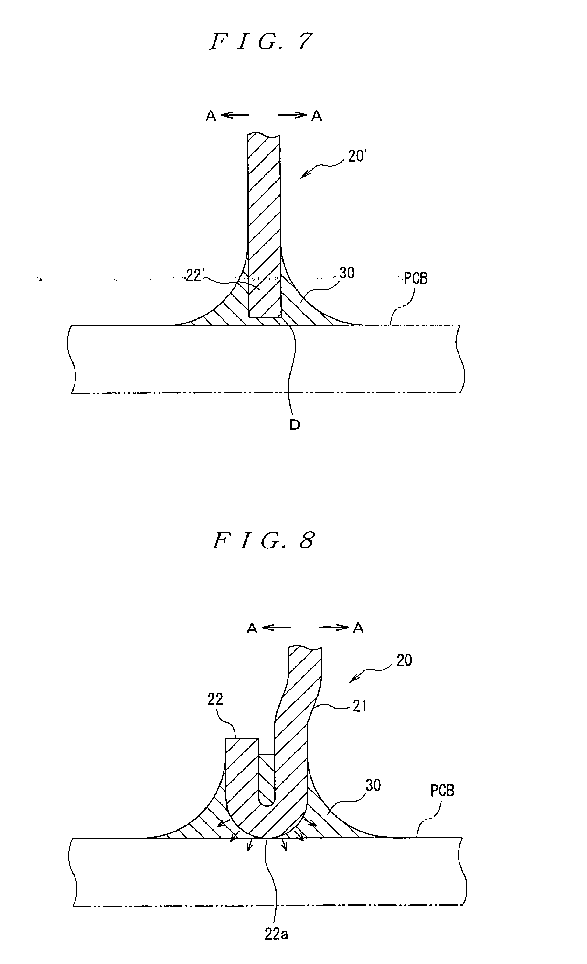

Furthermore, as is shown in FIG. 7, it is also conceivable to use fixers 20' whose solder connection parts 22' are not formed in the shape of the letter U in order to reduce the mounting area of the fixers 20', and to connect the solder connection parts 22' of these fixers 20' by soldering onto the circuit board PCB in an upright state. If this is done, in cases where an external force that causes the fixers 20' to move in the horizontal directions indicated by the arrows A acts on the fixers 20' as shown in FIG. 7 due to vibration, changes in ambient temperature, or other such factors, stress on the solder is concentrated on the edges D of the solder connection parts 22', creating the risk of generating cracking in the solder, so that this is not desirable.

In the case of the present embodiment, on the other hand, in cases where an external force that causes the fixers 20 to move in the horizontal directions indicated by the arrows A acts on the fixers 20 as shown in FIG. 8 due to vibration, changes in ambient temperature, or other such factors, stress on the solder is dispersed around the U-shaped portions of the solder connection parts 22, so that it is possible to reduce the likelihood of generating cracking in the solder.

Moreover, the pair of holding parts 23, 23 that are bent outward are provided at either end in the direction of width of the upper edge of the fastening part 21 of each fixer 20. These holding parts 23, 23 contact the shoulder parts 16, 16 formed on the housing 10 as described above, and reinforce the joining of the fixers 20 and housing 10 together with the fastening parts 21 when the electrical connector 1 is mounted on the circuit board PCB. If the holding parts 23, 23 are not provided, the fixers 20 are fastened to the housing 10 solely by the thin plate-form fastening parts 21, so that in cases where an external force acts which pulls the housing 10 away from the circuit board PCB in the vertical direction indicated by the arrow B in FIG. 6(C), the lower end edges or the locking projections 21a of the fastening parts 21 bite into the resin of the housing 10, creating the risk of generating cracking or breaking therein. By contrast, if the pair of holding parts 23, 23 that hold the housing 10 by contacting the shoulder parts 16, 16 formed on the housing 10 are provided at either end in the direction of width of the upper edge of the fastening part 21 of each fixer 20 as in the present embodiment, the resin constituting the shoulder parts 16, 16 of the housing 10 can be received by the holding parts 23, 23 in planar form when an external force acts which pulls the housing 10 away from the circuit board PCB in the vertical direction indicated by the arrow B, so that there is no generation of cracking or breaking in the housing 10.

In addition, because the fixers 20 are accommodated in the fixer accommodating recessed parts 14 formed in the side surfaces 10a of the housing 10, the mounting area of the electrical connector 1 can be reduced even further. An embodiment of the present invention has been described above. However, the present invention is not limited to this embodiment, and various alterations and modifications can be made.
For example, in the present embodiment, the description involves the electrical connector 1 as a surface-mount component comprising the fixers 20. However, it would also be possible to use relatively large components other than the electrical connector 1, e.g., terminal blocks, inductance components, or various types of module such as display elements as surface-mount components comprising fixers 20.
Furthermore, the fixers 20 can also be used in a component having the mounting structure of a through-hole type or the like other than a surface-mount component.

## Claims

1. A fixer for connecting an obj ect of connection by soldering onto the surface of a circuit board, wherein
this fixer comprises a plate-form fastening part that is fastened to a side surface of the object of connection and a solder connection part that extends from this fastening part and that is connected by soldering onto the surface of the circuit board, and
the end portion of the solder connection part is bent back outward in the shape of the letter U, and the rectilinear ridge part thereof contacts the surface of the circuit board.

2. The fixer according to Claim 1, wherein the fastening part is provided with holding parts that hold the object of connection by contacting shoulder parts formed on this object of connection.

3. A surface-mount component comprising the fixer according to Claim 1 or 2.

4. The surface-mount component according to Claim 3, wherein the fixer is accommodated in a recessed part formed in a side surface of the object of connection.

5. A mounting structure which uses the fixer according to Claim 1 or 2.
